# EUROPÄISCHE PATENTANMELDUNG

(11) **EP 1 956 381 A2**
(43) Veröffentlichungstag der Anmeldung: **13.08.2008**
(21) Anmeldenummer: 08001276.8
(22) Anmeldetag: 24.01.2008
(51) Int. Cl.: G01R 31/28

(54) **Elektrische Prüfeinrichtung zur Prüfung von elektrischen Prüflingen**

(30) Priorität: 08.02.2007 DE 102007007739; 14.01.2008 DE 102008004792
(71) Anmelder: Feinmetall GmbH, 71083 Herrenberg (DE)
(72) Erfinder: Steidle, Georg, 71111 Waldenbuch (DE); Böhm, Gunther, 71154 Nufringen (DE)
(74) Vertreter: Grosse, Rainer

(57) **Zusammenfassung**

Die Erfindung betrifft eine elektrische Prüfeinrichtung (1) zur Prüfung von elektrischen Prüflingen (2), vorzugsweise Wafern (3), mit einer elektrischen Anschlussvorrichtung (7), die Kontaktflächen (12) für eine Berührungskontaktierung einer mit dem Prüfling (2) kontaktierbaren Kontaktanordnung (5) aufweist und der eine Abstützeinrichtung (8) zugeordnet ist. Die Erfindung ist gekennzeichnet durch eine, nur radiales Temperaturausgleichsspiel durch Führungen (22) zulassende Mittenzentriereinrichtung (20) zur zentralen Ausrichtung von Abstützeinrichtung (8) und Anschlussvorrichtung (7) zueinander.

## Beschreibung

Die Erfindung betrifft eine elektrische Prüfeinrichtung zur Prüfung von elektrischen Prüflingen, vorzugsweise Wafern, mit einer elektrischen Anschlussvorrichtung, die Kontaktflächen für eine Berührungskontaktierung einer mit dem Prüfling kontaktierbaren Kontaktanordnung aufweist und der eine Abstützeinrichtung zugeordnet ist.

Elektrische Prüfeinrichtungen der Eingangs genannten Art dienen dazu, einen Prüfling elektrisch zu kontaktieren, um seine Funktionsfähigkeit zu testen. Die elektrische Prüfeinrichtung stellt elektrische Verbindungen zum Prüfling her, das heißt sie kontaktiert einerseits elektrische Anschlüsse des Prüflings und stellt andererseits elektrische Kontakte zur Verfügung, die mit einem Prüfsystem verbunden werden, das über die Prüfeinrichtung den Prüfling elektrische Signale zuführt, um für eine Funktionsprüfung beispielsweise Widerstandsmessungen, Strom- und Spannungsmessungen usw. durchzuführen. Da es sich bei dem elektrischen Prüfling oftmals um ein extrem kleines elektronisches Bauelement handelt, beispielsweise um einen Wafer, besitzt die Kontaktanordnung Kontaktelemente, die extrem kleine Abmessungen aufweisen und auch sehr eng nebeneinander angeordnet sind. Um nun eine Anschlussmöglichkeit zum erwähnten Prüfsystem zu schaffen, stehen die Kontaktelemente des Prüfkopfs in Berührungskontakt mit einer Anschlussvorrichtung, die eine Umsetzung auf einen größeren Kontaktabstand vornimmt und insofern das Anschließen von elektrischen Verbindungskabeln ermöglicht, die zum Prüfsystem führen. Da bei der Prüfung unterschiedliche Raumtemperaturen vorliegen können und vorzugsweise die Prüfung bei unterschiedlichen Prüflingstemperaturen durchgeführt wird, um seine Funktion auch innerhalb eines bestimmten Temperaturbereichs prüfen zu können, besteht bei den bekannten elektrischen Prüfeinrichtungen die Gefahr, dass auf Grund von thermisch bedingten Längenänderungen eine Kontaktgabe zwischen den Kontaktelementen und den zugeordneten Kontaktflächen der Anschlussvorrichtung auf Grund von entstehenden Positionsfehlern nicht immer einwandfrei gewährleistet ist. Diese Positionsverschiebungen resultieren aus unterschiedlichen Temperaturausdehnungskoeffizienten der verwendeten Materialien, wobei es aus konstruktiven Gründen erforderlich ist, bestimmte Materialien einzusetzen, so dass das geschilderte Problem nicht durch die Wahl des gleichen Materials für miteinander zusammenwirkende Bauteile gelöst werden kann. Vielmehr führen die erwähnten Längenänderungen zu mechanischen Spannungen, die beispielsweise die Anschlussvorrichtung verwerfen können, so dass sie ihre Planarität, die für eine sichere Kontaktgabe ebenfalls benötigt wird, verliert und/oder dass die Anschlussvorrichtung ihre zentrale Position durch temperaturbedingte Verschiebung verliert. Auch eine unterschiedlich starke Erwärmung einzelner Teile der Prüfeinrichtung kann zu Positionsverschiebungen führen. Bei der Berührungskontaktierung eines zu prüfenden Prüflings stützen sich die Kontaktelemente der Kontaktanordnung jeweils mit einem Ende am Prüfling und mit dem anderen Ende an der zugeordneten Kontaktfläche der elektrischen Anschlussvorrichtung ab, so dass bei einer Vielzahl von Kontaktelementen eine Vielzahl von Kontaktkräften und somit in der Summe eine hohe Kontaktkraft auf die Anschlussvorrichtung wirkt. Um diese Kontaktkraft ohne unzulässige Verformung von Bauteilen aufnehmen zu können, ist die Abstützeinrichtung vorgesehen. Dabei handelt es sich um ein relativ steifes Bauelement (Stiffener), an der sich die Anschlussvorrichtung abstützt. Bei den bekannten Prüfeinrichtungen entstehen durch die unterschiedlichen Ausdehnungskoeffizienten von Anschlussvorrichtungen und Abstützeinrichtung mechanische Spannungen, die zu Formänderungen führen können. Auch die Position von Abstützeinrichtung und Anschlussvorrichtung zueinander ist dann nicht mehr eindeutig festgelegt, wenn es auf Grund von Temperaturbeaufschlagung und den damit verbundenen Temperaturausdehnungen zu Verschiebungen der Bauelemente kommt. Für die Funktion der elektrischen Prüfeinrichtung ist es jedoch sehr wichtig, dass sich über einen weiten Temperaturbereich hinweg die Mitte/das Zentrum der Abstützeinrichtung relativ zu der Mitte/dem Zentrum der Anschlussvorrichtung und/oder weiteren Bauteilen der Prüfeinrichtung nicht verschiebt.

Der Erfindung liegt daher die Aufgabe zu Grunde, eine Prüfeinrichtung der eingangs genannten Art zur Verfügung zu stellen, die innerhalb eines großen Temperaturbereichs einwandfrei funktioniert und eine störungsfreie elektrische Prüfung des Prüflings gestattet.

Diese Aufgabe wird erfindungsgemäß gelöst durch eine, nur radiales Temperaturausgleichsspiel durch Führungen zulassende Mittenzentriereinrichtung zur zentralen Ausrichtung von Abstützeinrichtung und Anschlussvorrichtung zueinander. Die erfindungsgemäße Prüfeinrichtung, die insbesondere als Vertikal-Prüfkarte ausgebildet sein kann, besitzt somit zwischen Abstützeinrichtung und Anschlussvorrichtung die Mittenzentriereinrichtung, die sicherstellt, dass durch Temperaturänderungen auftretende Längenänderungen nur von dem jeweiligen Zentrum der erwähnten Bauteile ausgehen und jeweils in radialer Richtung auf Grund der dementsprechend gestalteten Führungen vorliegen. Die Führungen können insbesondere als Gleitführungen ausgebildet sein. Die Zentren der Abstützeinrichtung und der Anschlussvorrichtung liegen einander diametral gegenüber; sie befinden sich insbesondere auf einer gleichen Mitten-Hochachse, der genannten Bauteile. Da somit erfindungsgemäß zwar auf Grund der unterschiedlichen Materialien Längenänderungen durch Temperaturänderungen auftreten werden, sich jedoch durch die erwähnten Mittenzentriereinrichtung in Verbindung mit den radialen Führungen nicht derart groß aufsummieren, dass Verwerfungen auftreten und/oder eine Stirnfläche eines Kontaktelements nicht mehr die zugehörige Kontaktfläche der Anschlussvorrichtung trifft, ist eine sichere Funktion und eine sichere Kontaktgabe gewährleistet. Durch das erfindungsgemäße Vorgehen wird insbesondere die Befestigung der Abstützeinrichtung an der Anschlussvorrichtung auf Grund der Mittenzentriereinrichtung so ausführt, dass die Zentren beider Bauteile auch bei starken Temperaturschwankungen immer genau aufeinander liegen. Gleichzeitig werden Spannungen in der Baugruppe vermieden.

Nach einer Weiterbildung der Erfindung ist vorgesehen, dass die Mittenzentriereinrichtung außerhalb der Kontaktanordnung angeordnet ist. Diese Ausgestaltung gestattet es, den Bereich der Kontaktanordnung von den Zentriermitteln, also den Führungen, freizuhalten, so dass das Gebiet um das jeweilige Zentrum von Anschlussvorrichtungen und Kontaktanordnung ausschließlich für die Aufnahme von stiftförmigen Kontaktelementen zur Verfügung steht und daher eine Vielseitigkeit zur Anpassung an unterschiedliche Prüflinge erhalten bleibt.

Es ist vorteilhaft, wenn die Mittenzentriereinrichtung mindestens drei, insbesondere vier oder mehr als vier, winkelversetzt zueinander angeordnete Führungen aufweist. Vorzugsweise liegen diese drei Führungen um 120° zueinander winkelversetzt oder die erste der drei Führungen schließt mit der zweiten Führung einen 90°-Winkel und die zweite Führung mit der dritten Führung ebenfalls einen 90°-Winkel ein, so dass die dritte Führung zur ersten Führung 180° winkelversetzt liegt. Hierdurch ist die Zentrierung eindeutig bestimmt, das heißt in der Kontaktebene (X-Y-Ebene) kann es nicht zu einem Positionsversatz des Zentrums der Prüfeinrichtung kommen. Insbesondere kann vorgesehen sein, dass vier Führungen zum Einsatz kommen, die zueinander um 90° winkelversetzt liegen. Auch eine größere Anzahl von Führungen ist denkbar.

Eine Weiterbildung der Erfindung sieht vor, dass mindestens eine der Führungen durch einen Vorsprung an der Abstützeinrichtung und/oder an der Anschlussvorrichtung und eine den Vorsprung mit radialem Spiel und in Unfangsrichtung spielfrei aufnehmende Vertiefung an der Anschlussvorrichtung und/oder der Abstützeinrichtung gebildet ist. Vorzugsweise sind alle Führungen derart ausgestaltet. Die Führung lässt daher eine Verlagerung des Vorsprungs in der Vertiefung nur in einer Richtung zu, wobei es sich bei dieser Richtung um die radiale Richtung handelt, also -ausgehend von dem Zentrum der Prüfeinrichtung- entsprechend jeweils radial nach außen. Quer zur radialen Richtung verläuft -parallel zur Prüfebene- die erwähnte Umfangsrichtung, in der keine Spielfreiheit besteht, so dass ein Drehversatz zwischen Abstützeinrichtung und Anschlussvorrichtung ausgeschlossen ist. Senkrecht auf der Prüfebene, also in axialer Richtung erfolgt bei der Prüfung ein Annähern der Kontaktanordnung und dem Prüfling, um den Prüfling zu kontaktieren.

Insbesondere kann vorgesehen sein, dass der Vorsprung als Profilstift ausgebildet ist. Das Querschnittsprofil des Profilstifts ist kreisförmig oder vorzugsweise nicht kreisförmig, sondern abweichend von einer Kreisform, beispielsweise rechteckig oder quadratisch, um im Zusammenspiel mit den Wandungen der Vertiefung die Radialführung zu gewährleisten.

Insbesondere ist die Vertiefung als Durchbruch, vorzugsweise als Langloch ausgebildet.

Eine Weiterbildung der Erfindung sieht vor, dass der Vorsprung an seiner Mantelfläche Führungsmittel aufweist, die jeweils parallel zur radialen Richtung der Prüfeinrichtung verlaufen. Bei den Führungsmitteln handelt es sich insbesondere um parallele, ebene Führungsflächen des Vorsprungs.

Insbesondere kann die Vertiefung parallele Vertiefungswandungen aufweisen, die jeweils parallel zur radialen Richtung der Prüfeinrichtung verlaufen. Zwischen den Vertiefungswandungen wird der Vorsprung spielfrei beziehungsweise im Wesentlichen spielfrei aufgenommen, in der Art, dass er sich nur radial innerhalb der zugeordneten Vertiefung verlagern kann. Die jeweilige radiale Richtung wird bevorzugt von einer gedachten Geraden angegeben, die eine Mittelachse der Prüfeinrichtung schneidet, wobei die Mittelachse, insbesondere Mitten-Hochachse durch die Mitte/das Zentrum von Abstützeinrichtung und/oder Anschlussvorrichtung verläuft und sich die gedachte Gerade rechtwinklig zur Mittelachse erstreckt.

Die Anschlussvorrichtung kann bevorzugt als Leiterplatte ausgebildet sein. Hierbei handelt es sich insbesondere um eine mehrlagige Leiterplatte, das heißt sie weist Leiterbahnen auf, die in unterschiedlichen Ebenen der Platte liegen. Die Leiterbahnen führen einerseits zu den erwähnten Kontaktflächen, die mit Kontaktelementen, insbesondere Kontaktnadeln, der Kontaktanordnung elektrisch zusammenwirken und führen andererseits zu Anschlüssen, die beispielsweise über Kabelverbindungen zum genannten Prüfsystem führen. Als Kontaktelemente kommen insbesondere Kontaktstifte in Frage, die eine Kontaktstiftanordnung bilden. Insbesondere werden Federkontaktstifte verwendet oder -bei sehr kleinen Abmessungen- Knickdrähte. Die Kontaktelemente sind bevorzugt längsverschieblich in der Kontaktanordnung gelagert. Die Kontaktanordnung ist bevorzugt als Kontaktkopf ausgebildet.

Die Zeichnungen veranschaulichen die Erfindungen anhand eines Ausführungsbeispiels und zwar zeigt:
- Figur 1: eine schematische Längsschnittsansicht durch eine elektrische Prüfeinrichtung und
- Figur 2: eine schematische Querschnittsansicht durch die Prüfeinrichtung der Figur 1 im Bereich von Gleitführungen einer Mittenzentriereinrichtung.

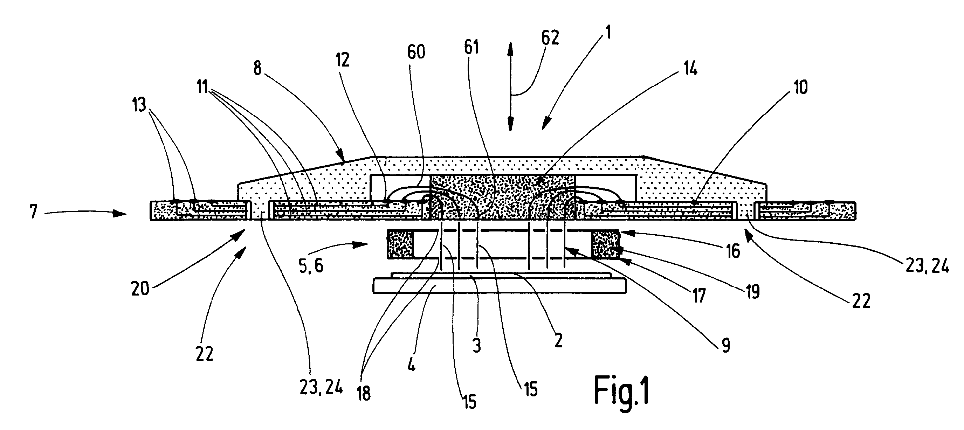

Die Figur 1 zeigt in schematischer Darstellung einen Längsschnitt durch eine elektrische Prüfeinrichtung 1, die zur elektrischen Berührungskontaktierung eines elektrischen Prüflings 2 dient. Die Prüfeinrichtung 1 ist mittels nicht dargestellter elektrischer Kabelverbindungen an ein ebenfalls nicht dargestelltes Prüfsystem angeschlossen, um den Prüfling 2 einer elektrischen Prüfung zu unterziehen. Der Prüfling 2, der insbesondere als Wafer 3 ausgebildet sein kann, befindet sich auf einem abstützenden Träger 4, der gekühlt oder geheizt werden kann. Auf diese Art und Weise ist es möglich, den Prüfling während der elektrischen Prüfung unterschiedlichen Temperaturen auszusetzen, beispielsweise im Bereich von -50°C bis +200°C, um zu prüfen, ob er in diesem Temperaturbereich einwandfrei arbeitet.

Zur Berührungskontaktierung entsprechender elektrischer Anschlussstellen des Wafers 3 ist die Prüfeinrichtung 1 vorgesehen.

Die Prüfeinrichtung 1 weist einen Kontaktkopf 6 und eine Anschlussvorrichtung 7 auf. Die Anschlussvorrichtung 7 stützt sich an einer Abstützeinrichtung 8 ab. Der Kontaktkopf 6, der allgemein als Kontaktanordnung 5 bezeichnet werden kann, ist mit einer Vielzahl von längsverschieblich gelagerten Kontaktelementen 9 versehen, die mit ihren einen Endbereichen dem Prüfling 2 und mit ihren anderen Endbereichen der Anschlussvorrichtung 7 zugeordnet sind. Die Anschlussvorrichtung 7 ist als mehrlagige Leiterplatte 10 mit Leiterbahnen 11 ausgebildet, wobei die Leiterbahnen 11 an ihren dem Kontaktkopf 6 abgewandten Enden Kontaktflächen 12 aufweisen, die über Drahtverbindungen 60 zu Kontaktflächen 61 führen, die den jeweiligen Kontaktelementen 9 zugeordnet sind. Die Kontaktflächen 61 werden insbesondere von den Stirnenden der Drahtverbindungen 60 gebildet. Die Leiterbahnen 11 besitzen an ihren anderen, radial außen liegenden Enden elektrische Anschlussflächen 13, die über die erwähnten, nicht dargestellten Kabelverbindungen mit dem nicht dargestellten Prüfsystem verbindbar sind. Die Anordnung ist von der Art getroffen, dass die Anschlussvorrichtung 7 eine Umsetzvorrichtung bildet, das heißt der sehr enge Abstand der sehr kleinen Kontaktflächen 61 (Durchmesser zum Beispiel 50 bis 300 µm) wird über die Drahtverbindungen 60 und die Leiterbahnen 11 in größere Abstände der Anschlussflächen 13 umgesetzt. Die Anschlussflächen 13 haben jeweils eine Größe, die ermöglicht, auf einfache Art Kontakt mit den nicht dargestellten Kabelverbindungen herstellen zu können.

Bei der Prüfung des Prüflings 2 bewegt sich die Prüfeinrichtung 1 auf den Prüfling 2 zu und/oder der Prüfling 2 bewegt sich auf die Prüfeinrichtung 1 zu, so dass die Stirnenden der Kontaktelemente 9 einerseits auf den Wafer 3 und andererseits auf die Kontaktflächen 61 auftreffen. Da die Kontaktelemente 9 insbesondere als Knickdrähte 15 ausgebildet sind, das heißt, sie sind in axialer Richtung durch Durchbiegung leicht federnd gestaltet, ist eine einwandfreie Kontaktierung möglich. Der Kontaktkopf 6 besitzt zwei mit Abstand zu einander liegende parallele Keramikplatten 16 und 17, die mit Lagerbohrungen 18 zur Aufnahme der Knickdrähte 15 versehen sind. Die parallele Abstandslage der beiden Keramikplatten 16 und 17 sind mittels eines Abstandshalters 19 realisiert.

Die Drahtverbindungen 60 verlaufen zumindest abschnittsweise durch ein Anschlussgehäuse 14, das beispielsweise als Gießblock ausgebildet ist und die Drahtverbindungen 60 in fester Position hält. Das Anschlussgehäuse 14 ist Teil der Anschlussvorrichtung 7. Die Anschlussvorrichtung 7 stützt sich an der Abstützeinrichtung 8 ab, so dass erstere mechanisch stabilisiert wird. Das gilt sowohl für die Leiterplatte 10 als auch für das Anschlussgehäuse 14.

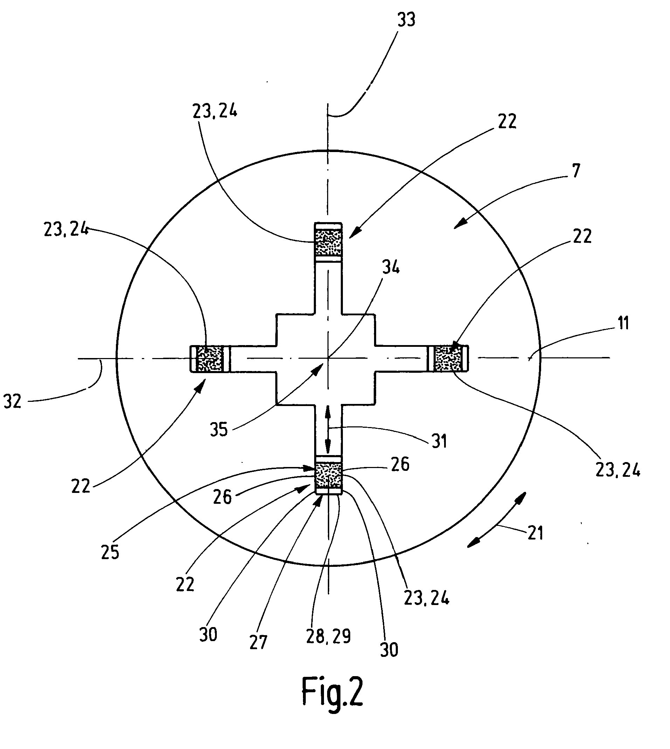

Anstelle der bisher bekannten, starren, festen Verbindung zwischen der Abstützeinrichtung 8 und der Anschlussvorrichtung 7 ist erfindungsgemäß eine Mittenzentriereinrichtung 20 zwischen den genannten Bauteilen vorgesehen, die -gemäß der Figuren 1 und 2- von vier, in Umfangsrichtung (Doppelpfeil 21) mit einem Winkelabstand von 90° zueinander versetzt liegenden Führungen 22, insbesondere Gleitführungen, gebildet ist, wie dies insbesondere aus der Figur 2 hervorgeht. Die Figur 2 lässt erkennen, dass die Leiterplatte 11 der Anschlussvorrichtung 7 als Kreisplatte ausgebildet ist.

Gemäß der Figuren 1 und 2 weisen die Gleitführungen 22 jeweils einen Vorsprung 23 in Form eines Profilstiftes 24 auf, wobei die Vorsprünge 23 insbesondere einstückig an der Abstützeinrichtung 8 ausgebildet sind. Der Vorsprung 23 weist mit seinem freien Ende in axialer Richtung 62. Diese Richtung entspricht der Kontaktierungsrichtung, also der Richtung der bei der Prüfung erforderlichen Relativbewegung zwischen Prüfeinrichtung 1 und Prüfling 2 zur Kontaktierung. Der Profilstift 24 weist an seiner Mantelfläche 25 (Figur 2) zwei, einander gegenüberliegende, parallele, ebene Führungsflächen 26 auf. Der Profilstift 24 weist ein rechteckförmiges Querschnittsprofil auf. Er erstreckt sich mit seinem freien Ende bis in eine Vertiefung 27 hinein, die an der Anschlussvorrichtung 7, im vorliegenden Ausführungsbeispiel an der Leiterplatte 10, ausgebildet ist. Die Vertiefung 27 ist bevorzugt als Durchbruch 28 ausgestaltet. Sie besitzt eine Langlochform, stellt also ein Langloch 29 dar. Die Vertiefung 27 weist zwei parallel zueinander verlaufende Vertiefungswandungen 30 auf, die derart beabstandet zueinander liegen, dass sie die Führungsflächen 26 des Profilstifts 24 im Wesentlichen spielfrei aufnehmen. Die Längserstreckung den Langlochs 29 ist größer ausgebildet, als die entsprechende Abmessung des Profilstifts 24, so dass zwischen Abstützeinrichtung 8 und Anschlussvorrichtung 7 eine Relativbewegung in Richtung des eingezeichneten Doppelpfeils 31, der eine radiale Richtung angibt, stattfinden kann. Quer dazu ist eine Relativbewegung nicht möglich, da dies durch die Führung der Führungsflächen 26 an den Vertiefungswandungen 30 verhindert ist.

Aus der Figur 2 wird deutlich, dass die vier Gleitführungen 22 derart angeordnet sind, dass sie auf zwei, sich unter einem Winkel von 90° kreuzenden, gedachten Radialen 32 und 33 liegen, wobei sich die Radialen 32 und 33 in einem Mittelpunkt 34 kreuzen und der Mittelpunkt 34 das Zentrum 35 bildet, beziehungsweise die Mitte der Prüfeinrichtung 1, damit die Mitte der Anschlussvorrichtung 7 und die Mitte der Abstützeinrichtung 8 bildet. Um das Zentrum 35 sind die Knickdrähte 15 angeordnet, die zur Kontaktanordnung 5 gehören. Die vier Gleitführungen 22 befinden sich radial außen liegend zur Kontaktanordnung 5, wobei die Längserstreckung der Langlöcher 29 derart orientiert ist, dass sie jeweils mittig auf den Radialen 32 und 33 liegen. Entsprechend der Langlochausrichtungen der Langlöcher 29 sind die Führungsflächen 26 der einzelnen Profilstifte 24 ausgestaltet.

Aus alledem wird deutlich, dass die Bauteileabstützeinrichtung 8 und Anschlussvorrichtung 7 bei einer durch Temperaturbeaufschlagung entstehenden Materialausdehnung beziehungsweise Materialschrumpfung auf Grund der Mittenzentriereinrichtung 20 im Bereich des Zentrums 35 zueinander fixiert sind und Relativbewegungen nur in Richtung der Radialen 32 und 33 erfolgen können. Hierdurch ist sichergestellt, dass die erwähnten Längenänderungen, die aus unterschiedlichen Temperaturausdehnungskoeffizienten der verwendeten Materialien der Bauteile resultieren, nicht dazu führen können, dass derart große Versatzstrecken auftreten, dass Verwerfungen entstehen und/oder die dem Anschlussgehäuse 14 zugeordneten Stirnenden der Knickdrähte 15 nicht mehr auf die Kontaktflächen 61 treffen. Die Mittenzentrierung auf Grund der Mittenzentriereinrichtung 20 verhindert daher große Versatzstrecken, da die auftretenden Längenänderungen vom Zentrum ausgehend beginnen und somit symmetrisch zur Mitte liegen und damit -in radialer Richtung gesehennur halb so groß sind, wie ein Versatz, der bei Nichtverwendung der Erfindung auftreten könnte, wenn außen liegende Knickdrähte 15 zentral auf die zugeordneten Kontaktflächen 61 aufsetzen, so dass die diametral gegenüberliegenden, ebenfalls außen liegenden Knickdrähte auf Grund der sich aufsummierenden Längenausdehnungen beziehungsweise Längenschrumpfungen zu Fehlkontakten führen. Auch sind auf Grund der erfindungsgemäßen Mittenzentriereinrichtung 20 Materialspannungen in den zugeordneten Bauteilen vermieden.

Beim vorliegenden Ausführungsbeispiel ist die Abstützeinrichtung 8 kreuzförmig ausgebildet. Nach anderen, nicht dargestellten Ausführungsbeispielen kann jedoch auch vorgesehen sein, dass die Abstützeinrichtung 8 ringförmig oder als Speichenrad ausgebildet ist.

Auf Grund der vorliegenden Erfindung ist die Befestigung der Abstützeinrichtung 8 an der Anschlussvorrichtung 7 so ausgeführt, dass die beiden Zentren der beiden Bauteile -wie bereits erwähnt- auch bei starken Temperaturschwankungen immer genau aufeinander liegen, so dass Kontaktsicherheit gegeben ist und es werden die bereits erwähnten mechanischen Spannungen der Baugruppe vermieden.

Nach einem weiteren, nicht dargestellten Ausführungsbeispiel kann auch eine kinematische Umkehr realisiert sein, das heißt, die Vertiefungen 27 befinden sich nicht in der Anschlussvorrichtung 7, sondern in der Abstützeinrichtung 8. Die Vorsprünge 23 sind dann als an der Anschlussvorrichtung 7 angeordnete Stifte ausgebildet.

Ferner kann bei allen Ausführungsbeispielen vorgesehen sein, dass die Gleitführungen 22 derart ausgestaltet sind, dass an ihnen auch Auflageflächen der Abstützeinrichtung 8 auf der Anschlussvorrichtung 7, insbesondere der Leiterplatte 10, ausgebildet sind. An diesen Auflageflächen der Gleitführungen 22, die Passungen bilden, kann durch Unterlegen oder durch einen Verstellmechanismus eine Neigung der Abstützeinrichtung 8 relativ zur Anschlussvorrichtung 7, insbesondere zur Leiterplatte 10, herbeigeführt werden.

## Patentansprüche

1. Elektrische Prüfeinrichtung zur Prüfung von elektrischen Prüflingen, vorzugsweise Wafern, mit einer elektrischen Anschlussvorrichtung, die Kontaktflächen für eine Berührungskontaktierung einer mit dem Prüfling kontaktierbaren Kontaktanordnung aufweist und der eine Abstützeinrichtung zugeordnet ist, **gekennzeichnet durch** eine, nur radiales Temperaturausgleichsspiel **durch** Führungen (22) zulassende Mittenzentriereinrichtung (20) zur zentralen Ausrichtung von Abstützeinrichtung (8) und Anschlussvorrichtung (7) zueinander.

2. Prüfeinrichtung nach Anspruch 1, **dadurch gekennzeichnet, dass** die Mittenzentriereinrichtung (20) außerhalb der Kontaktanordnung (5) angeordnet ist.

3. Prüfeinrichtung nach einem der vorhergehenden Ansprüche, **dadurch gekennzeichnet, dass** die Mittenzentriereinrichtung (20) mindestens drei, insbesondere vier oder mehr als vier, winkelversetzt zueinander angeordnete Führungen (22) aufweist.

4. Prüfeinrichtung nach einem der vorhergehenden Ansprüche, **dadurch gekennzeichnet, dass** mindestens eine der Führungen (22) durch einen Vorsprung (23) an der Abstützeinrichtung (8) und/oder an der Anschlussvorrichtung (7) und eine dem Vorsprung (23) mit radialem Spiel und in Umfangsrichtung spielfrei aufnehmende Vertiefung (27) an der Anschlussvorrichtung (7) und/oder der Abstützeinrichtung (8) gebildet ist.

5. Prüfeinrichtung nach einem der vorhergehenden Ansprüche, **dadurch gekennzeichnet, dass** der Vorsprung (23) ein Profilstift (24) ist.

6. Prüfeinrichtung nach einem der vorhergehenden Ansprüche, **dadurch gekennzeichnet, dass** die Vertiefung (27) ein Durchbruch (28) ist.

7. Prüfeinrichtung nach einem der vorhergehenden Ansprüche, **dadurch gekennzeichnet, dass** die Vertiefung (27) ein Langloch (29) ist.

8. Prüfeinrichtung nach einem der vorhergehenden Ansprüche, **dadurch gekennzeichnet, dass** der Vorsprung (23) an seiner Mantelfläche (25) Führungsmittel aufweist, die jeweils parallel zur radialen Richtung der Prüfeinrichtung (1) verlaufen.

9. Prüfeinrichtung nach einem der vorhergehenden Ansprüche, **dadurch gekennzeichnet, dass** die Vertiefung (27) parallele Vertiefungswandungen (30) aufweist, die jeweils parallel zur radialen Richtung der Prüfeinrichtung (1) verlaufen.

10. Prüfeinrichtung nach einem der vorhergehenden Ansprüche, **dadurch gekennzeichnet, dass** die jeweilige radiale Richtung von einer gedachten Geraden angegeben wird, die eine Mittelachse der Prüfeinrichtung schneidet, wobei die Mittelachse durch die Mitte (34)/das Zentrum (35) von der Abstützeinrichtung (8) und/oder der Anschlussvorrichtung (7) verläuft und die Gerade rechtwinklig zur Mittelachse verläuft.

11. Prüfeinrichtung nach einem der vorhergehenden Ansprüche, **dadurch gekennzeichnet, dass** die Anschlussvorrichtung (7) eine Leiterplatte (10) ist.

12. Prüfeinrichtung nach einem der vorhergehenden Ansprüche,
**dadurch gekennzeichnet, dass** die Kontaktanordnung (5) als Kontaktkopf (6) ausgebildet ist, der eine Kontaktstiftanordnung (61) mit stiftförmigen Kontaktelementen (9) aufweist.

13. Prüfeinrichtung nach einem der vorhergehenden Ansprüche, **dadurch gekennzeichnet, dass** die Kontaktelemente (9) längsverschieblich gelagerte Knickdrähte (15) sind.

14. Prüfeinrichtung nach einem der vorhergehenden Ansprüche, **dadurch gekennzeichnet, dass** die Führungen (22) Gleitführungen sind.
